## Europäisches Patentamt

## European Patent Office

## Office européen des brevets

(11) Publication number: **0 132 925**
**B1**

# EUROPEAN PATENT SPECIFICATION

(45) Date of publication of patent specification: **07.01.88**

(51) Int. Cl.⁴: **G 01 R 35/00**, G 06 F 11/26

(21) Application number: **84303597.3**

(22) Date of filing: **29.05.84**

(54) Diagnostic system for a raster scan type display device.

(30) Priority: **30.06.83 US 509560**

(43) Date of publication of application:
**13.02.85 Bulletin 85/07**

(45) Publication of the grant of the patent:
**07.01.88 Bulletin 88/01**

(84) Designated Contracting States:
**DE FR GB NL**

(56) References cited:
**EP-A-0 087 608**
**DE-A-3 034 278**

**IBM TECHNICAL DISCLOSURE BULLETIN, vol.
20, no. 11A, April 1978, pages 4483-4484, New
York, US; M.P. DYCHE et al.: "Dual use of logic
for normal operation and off-line diagnostic
testing"**

(73) Proprietor: **TEKTRONIX, INC.
Tektronix Industrial Park D/S Y3-121 4900 S.W.
Griffith Drive P.O. Box 500
Beaverton Oregon 97077 (US)**

(72) Inventor: **Olin, Daniel C.
3255 S.E. Caruthers
Portland Oregon 97214 (US)**

(74) Representative: **Wombwell, Francis et al
Potts, Kerr & Co. 15, Hamilton Square
Birkenhead Merseyside L41 6BR (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

### Background of the Invention

The present invention relates to a circuit as defined in the precharacterizing part of claim 1.

Raster scan type cathode-ray tube (CRT) display devices produce flicker free displays containing a great deal of information composed of many kinds of character and images. These devices also produce various video modes, such as normal video (i.e. intensified characters on a dark background), reverse video (i.e. dark characters on an intensified background), or highlighting (i.e. half intensity shading of characters).

Raster scan types CRT displays that are used for displaying alphanumeric information and various patterns, such as portions of logic timing waveforms, cursors, and the like, are generally divided into a matrix of M rows and N columns. Each coordinate of the M × N display matrix defines a character location on the display and is subdivided into a p × q character matrix that defines pixel locations on the display. A character read only memory (ROM) stores a plurality of electrical patterns, representative of character information, in p' × q' matrices corresponding in size to the p × q matrices of the M × N display matrix. A display random access memory (RAM) stores character-address and character-attribute information corresponding to the coordinates of the M × N display matrix in separate memory locations. In the above type display, the character-attribute information defines the various video-modes.

To produce a display on the CRT, the display RAM outputs character-address and video-mode information in synchronization with the raster scan operation of the display device. When addressed by the display RAM, the character ROM outputs a corresponding electrical pattern, representative of character information, to the video display circuitry. Concurrently, the video-mode information is coupled to the video display circuitry to enable the appropriate video mode circuits. The output of the video display circuitry is coupled to the Z-axis control grid of the CRT to produce the output display.

Diagnostic self-test systems have been used in raster scan type CRT display devices for verifying the proper operations of the circuits within the device before use. Diagnostic self-test systems generally have a diagnostic program, stored in a read only memory (ROM), a microprocessor, and readback latches placed at strategic points in the circuit. Each readback latch monitors the output data from that portion of the circuit to be tested and couples that data to the microprocessor via the data bus.

During a diagnostic test of the display circuitry, for example, checking the display RAM, the microprocessor writes known data values to the RAM under diagnostic program control. As the data is output from the RAM, a data latch monitors the output and couples the information to the microprocessor. The microprocessor compares the data from the latch with predetermined data to verify the operation of the RAM and the associated input and output circuitry. For diagnosing the character ROM, the contents of the ROM is output under program control and monitored by another data latch. The latched data is coupled to the microprocessor where a check sum is calculated for the entire contents of the ROM and compared with a predetermined value. In all cases, the data latches monitoring the output of the circuits under test must be connected to the bus of the microprocessor.

Raster scan type CRT display devices are increasingly being designed with more "user-friendly" features, such as horizontal and vertical smooth scrolling, cursors, positioning, parameter readouts, and the like. A conventional diagnostic self-test system for devices with large feature sets would require a great deal of additional circuitry for monitoring the various circuits. The cost of such a system would become prohibitively expensive.

A diagnostic self-test system is needed that verifies the proper operation of the display circuitry of a raster scan type CRT display device having a large feature set without the use of many feedback latches and the associated circuitry required to couple the monitored data to the data bus of the microprocessor.

### Summary of the Invention

The present invention is directed toward circuit as claimed in claim 1. In a diagnostic system for use in a raster scan type CRT display device a predetermined portion of a video output signal is sampled in timed relationship with multiple reference timing signals. A microprocessor, under diagnostic program control, stores known character-address and character-attribute information in a random access memory (RAM) at a location corresponding to a verification window. In the preferred embodiment, the verification window corresponds to the last eight pixel bits of the two hundredth raster line of the display. The stored character-address information is output from the RAM to a character read only memory (ROM) in timed relationship with the production of raster lines on a CRT type display and a character frequency reference signal. The character ROM outputs corresponding electrical patterns representative of the character information on a raster line base to the video display circuitry. Concurrently, the character-attribute information is coupled to an attribute circuit that enables the appropriate character-attribute circuit, such as normal or reverse video or highlighting, in the video display circuitry. The video output from the display circuitry is coupled to data latch that samples a portion of the video signal corresponding to the verification window and couples the data back to the microprocessor via a data bus where a comparison is made with known value.

By incorporating horizontal and vertical smooth scrolling functions in the display device, each pixel row of the electrical pattern, representative of the character information, can be sampled by the data latch. Since the video output signal is checked, the present invention can verify the proper operation of all data paths of the display circuitry of the display device. The present invention requires only a single sampling circuit as hardware.

A more complete understanding of the present invention and its various features, advantages, and objectives may be had by referring to the following detailed description and the accompanying drawings.

Brief Description of the Drawings

FIG. 1 illustrates a block diagram of a preferred embodiment of the present invention;

FIG. 2 illustrates a display screen for explaining the operation of the present invention;

FIG. 3A illustrates a magnified view of a part of the display screen for explaining the operation of the present invention;

FIG. 3B illustrates the contents of a memory for displaying the video signal of FIG. 3A; and

FIG. 4 illustrates a time chart for explaining the operation of a portion of the present invention.

Detailed Description of the Invention

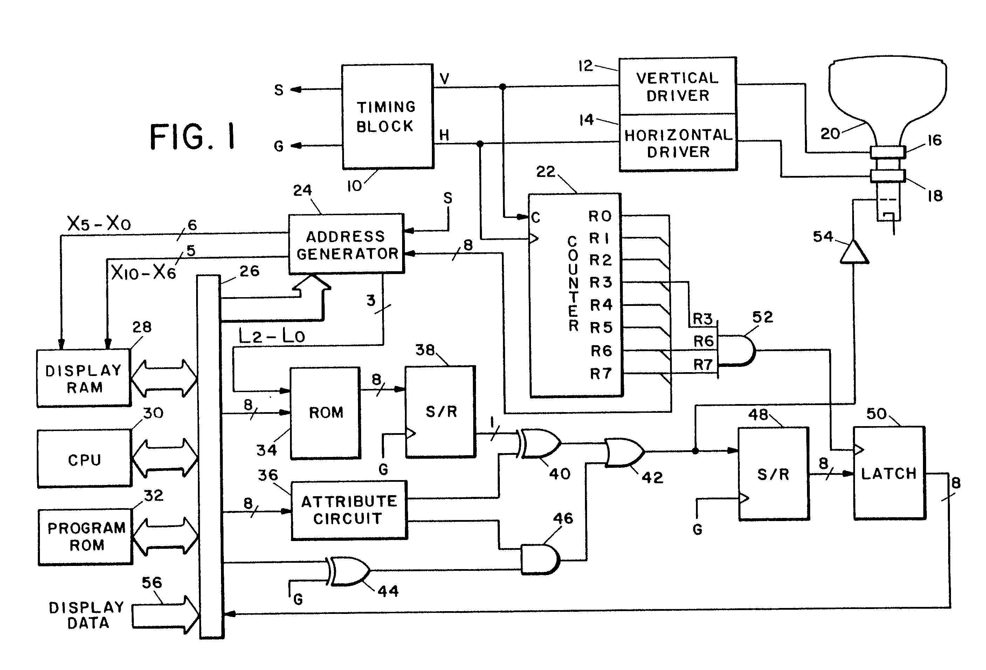

Referring to Fig. 1, there is shown a block diagram of a preferred embodiment of the present invention as used in a raster scan type CRT display device. Timing block 10 produces timing signals G and S that are respectively the pixel and character frequencies. In this embodiment, the pixel frequency is 9.6 MHZ and the character frequency is 1.2 MHZ. Timing block 10 also produces vertical and horizontal timing pulses, V and H respectively, that are in timed relationship with timing signals G and S. The V and H timing pulses are coupled to vertical and horizontal drivers 12 and 14 and to counter 22. Drivers 12 and 14 generate vertical and horizontal raster scan signals in response to timing pulses V and H. The vertical and horizontal raster scan signal are coupled to deflection yokes 16 and 18 respectively on CRT 20 for the production of raster lines on the screen of the CRT.

Counter 22 is coupled to an AND gate 52 and address generator 24. The address generator 24 is also coupled to receive the 1.2 MHZ character frequency S timing signal and data input from data bus 26. The outputs of address generator 24 are coupled to a display random access memory (RAM) 28 and a character read only memory (ROM) 34. The display RAM 28 is also coupled to data bus 26 along with a central processing unit 30, such as an 8080 or Z-80A microprocessor, a program read only memory (ROM) 32, which contains a diagnostic self test program, the character ROM 34, an attribute circuit 36 and exclusive OR gate 44.

The output of character ROM 34 is coupled to a parallel-to-serial shift register 38 that has its clock input coupled to receive the 9.6 MHZ G signal. The output of shift register 38 is coupled to one input of exclusive OR gate 40. The second input of exclusive OR gate 40 is coupled to the character attribute circuit 36. The output of exclusive OR gate 40 is coupled to one input of OR gate 42 that has its second input coupled to the output of AND gate 46. One input of AND gate 46 is coupled to character attribute circuit 36 while the other input is coupled to the output of exclusive OR gate 44. As previously mentioned, one input of exclusive OR gate 44 is coupled to data bus 26 while the other input is coupled to receive the 9.6 MHZ G signal.

The output of OR gate 42 is coupled to buffer amplifier 54 which is coupled to the Z-axis grid of CRT 20 and to serial-to-parallel shift register 48 that has a clock input coupled to receive the 9.6 MHZ G signal. The output of shift register 48 is coupled to a data latch 50 that has a clock input coupled to AND gate 52. The output of data latch 50 is coupled to data bus 26.

During normal display mode operation, character information and character-attribute information, defining various video modes, is input to display RAM 28 via data bus 26 and display data lines 56. The character and video mode information is stored at locations in display RAM 28 corresponding to character locations on the screen of CRT 20. The stored data in RAM 28 is output in response to address signals from address generator 24. The $L_0 - L_2$ and $X_6 - X_{10}$ output of address generator 24 correspond to the raster line count from counter 22, and the $X_0 - X_5$ output corresponds to the 1.2 MHZ character frequency S signal that defines the character boundaries.

The character and video-mode information is concurrently output to character ROM 34 and attribute circuit 36, respectively. ROM 34 contains a plurality of electrical patterns, corresponding to alphanumeric characters that are addressed by the display RAM 28 and the $L_0 - L_2$ raster line information. The parallel output of ROM 34 is coupled to parallel-to-serial shift register 38 that converts the parallel data to serial data at a 9.6 MHZ pixel rate of signal G. The serial data is coupled to one input exclusive OR gate 40. The other input of OR gate 40 is coupled attribute circuit 36.

The attribute circuit controls the outputs of exclusive OR gate 40 and AND gate 46 so as to produce video effects such as normal video, reverse video, and highlighting. When the signal output of attribute circuit 36 to exclusive OR gate 40 is a logic low, the output of gate 40 is not inverted, thus producing normal video. When the signal output is a logic high, the output of gate 40 is inverted with respect to the output of register 38 and the video is reversed. When the output signal of attribute circuit 36 to AND gate 46 is a logic low, the 9.6 MHZ G signal from exclusive OR gate 44 is prevented from reaching OR gate 42. When the output signal is a logic high the 9.6 MHZ signal is coupled to OR gate 42 to produce highlighting.

The video output from OR gate 42, which is composed of pixel patterns corresponding to alphanumeric characters and the superimposed video mode information, is coupled to a buffer amplifier 54 which amplifies the signal and couples it to the Z-axis grid of CRT 20. The video output signal is also coupled to a serial-to-parallel shift register that is clocked at the 9.6 MHZ G signal. The resultant parallel output is coupled to a data latch 50 that has its clock input coupled to the output of AND gate 52. In this embodiment, a clock pulse is produced by AND gate 52 when the raster line counter increments to line 200. The data from latch 50 is coupled to the data bus 26.

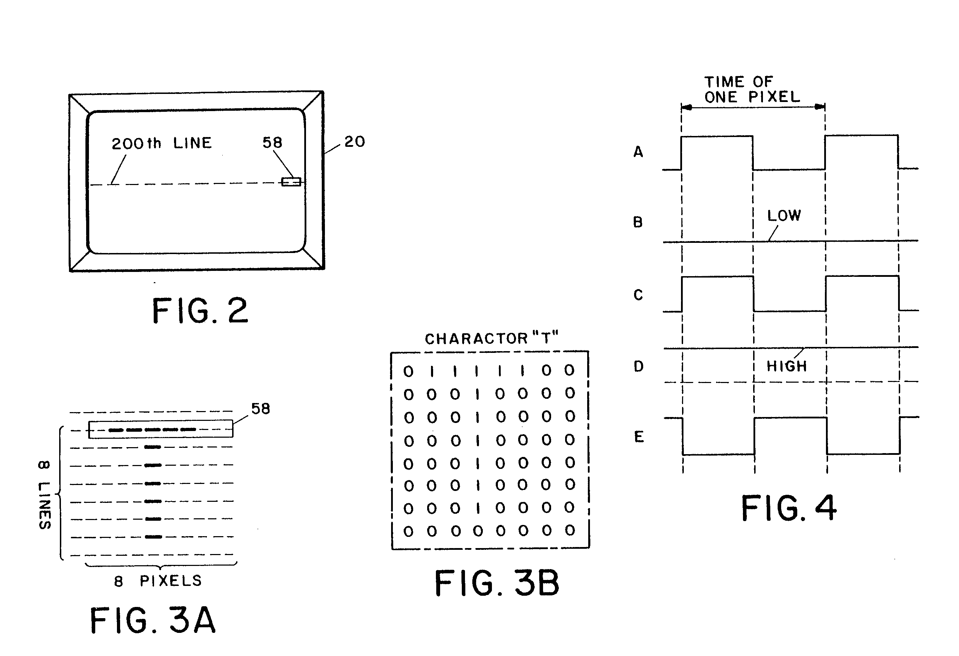

In order to more easily understand the diagnostic system of the present invention, the following description will be referenced to a video display on CRT 20. Referring to FIG. 2, there is shown the display screen of CRT 20 having a dashed line representative of raster line 200. A verification window, shown as block 58, corresponds to the last character column position on the CRT display and contains the last eight pixel bits of raster line 200.

During a diagnostic self-check, the microprocessor under program control, stores known character and video mode information at a location in RAM 28 corresponding to the verification window 58. As previously described, the contents of RAM 28 is output in response to address signals from address generator 24. The output of RAM 28 addresses ROM 34 and attribute circuit 36, which produce the combined video signal at the output of OR gate 42. The serial video output is continuously converted to parallel data by shift register 48 and coupled to data latch 50. When the inputs to AND gate 52 and all logic highs, representative of the end of the two-hundredth raster line, the output of AND gate 52 goes to a logic high causing the data latch 50 to sample the data that is present on its input of that time. The sampled data represents the last 8 pixel bits of raster line 200 corresponding to the verification window. This data is coupled to the microprocessor 30 via data bus 26 where the data is compared with a known value to establish verification of circuit operation.

By incorporating vertical and horizontal smooth scrolling in the display device, the diagnostic system can incrementally check the video output on a raster line and pixel basis. As an example, Figs. 3A and 3B show an electrical pattern from ROM 34 representative of the letter "T". As previously described, ROM 34 outputs the character data on a raster line basis. Initially, the first raster line of the character "T" is positioned within window 58 as shown in FIG. 3A. Data latch 50 samples the first line of data "01111100" ("7C" in hexadecimal), and couples the data via data bus 26 to microprocessor 30 where the data is stored in a stack memory. The microprocessor increments the raster line count in address generator 24 by one via data bus 26. This scrolls the data one raster line. The second line of the character "T" is now positioned within window 58, and the second line of data "0001000" ("10" in hexadecimal) is sampled and coupled to microprocessor 30. Microprocessor 30 computes the sum of the first and second lines of data and stores the result in a stack memory. The above-described operation is repeated until all eight lines of data are sampled and a computed checksum is produced. This value is compared with a predetermined checksum value for the character. If the checksums are equal, the contents of ROM 34 corresponding to the character "T" are correct and the video processing circuitry is operating properly. Each electrical pattern in ROM 34 can be checked in this manner and a checksum can be computed for each character. It is also possible to compute a total checksum for all the characters in ROM 34 and a compare the results with a predetermined value corresponding to the total checksum of the characters.

To perform a diagnostic check of the reverse video mode, the microprocessor stores a value in RAM 28 corresponding to the verification window that produces a blank character from ROM 34. The corresponding video mode information stored in RAM will cause a logic high output from the attribute circuit 36 to exclusive OR gate 40. The logic low output from ROM 34 will be inverted to a logic high output by exclusive OR gate 40. As previously described, the video output is sampled by data latch 50 and coupled to microprocessor 30 where a comparison is made between the sampled value and a known value corresponding to reversed blank character. If the comparison is true, then the reverse video mode is operating properly.

Referring now to FIG. 4, there is shown a timing diagram for explaining the diagnostic check of the highlighting mode. Signal A represents the 9.6 MHZ G signal corresponding to the pixel frequency. Signals B and D represent the signal input to exclusive OR gate 44 from data bus 26. Signal C and E represent the output from exclusive OR gate 44 when the signal input from data bus 26 is respectively low and high.

To perform a diagnostic check of the highlighting mode, the microprocessor stores a value in RAM 28 corresponding to the verification window that produces a blank character from ROM 34. The corresponding video mode information stored in RAM 28 will cause a logic high output from attribute circuit 36 to AND gate 46. The logic high on AND gate 46 enable the 9.6 MHZ output from exclusive OR gate to be coupled to OR gate 42. The output of OR gate 42 is coupled to shift register 48.

When the input to exclusive OR gate 44 from data bus 26 is low, the 9.6 MHZ signal is not inverted and is in phase with the 9.6 MHZ clock signal to shift register 48. Since the signals are in phase, the output of shift register 48 will be a series of logical highs. This output is sampled by data latch 50 and coupled to microprocessor 30 where a comparison is made with a predetermined known value corresponding to a video signal of logical highs.

When the input to exclusive OR gate 44 from data bus 26 is high, the 9.6 MHZ signal is inverted and is 180° out of phase with the 9.6 MHZ clock signal to shift register 48. This causes the shift register to output series of logical lows. This output is sampled by data latch 50 and coupled to the microprocessor 50 where a comparison is made with a predetermined value corresponding to video signal of logical lows. If both the logical high and low comparison are true, then the highlighting video-mode is operating properly.

It will be obvious to those having ordinary skill in the art that many changes may be made in the above-described details of the preferred embodiment of the present invention. For example, the verification window may be positioned at any desired part of the display screen, e.g., the initial eight pixel bits of the first raster line. Additionally, the number of pixel bits sampled by data latch 50 is determined by the number of pixels contained in the character segment width. Therefore, the scope of the present invention should be determined only by the following claims.

## Claims

1. A signal monitoring circuit for a diagnostic self-check circuit of a raster scan type display device having means for comparing a stored reference signal with a sampled signal characterized by:

means (10, 22) for producing a plurality of reference timing signals (V, H, S, G, R3·R6·R7) in timed relationship with one another;

signal producing means (24, 28, 30, 32, 34, 38) for producing a serial output signal, production of said serial output signal being clocked by one (G) of said reference timing signals;

means (48) coupled to receive said serial output signal for producing a sequence of parallel output signals corresponding to successive portions of said serial output signal, production of said parallel output signals being clocked by said one (G) of said reference timing signals; and

means (28, 30, 32, 50) coupled to receive said parallel output signals for sampling and monitoring one of said parallel output signals corresponding to a selected portion of said serial output signal to form the sampled signal, sampling of said one parallel output signal being clocked by a second one (R3·R6·R7) of said reference timing signals.

2. A signal monitoring circuit as in claim 1 wherein the sampling and monitoring means is further characterized by:

a processor (30, 32) for receiving said one parallel output signal corresponding to the sampled signal and for comparing the sampled signal with the stored reference signal; and

latch means (50), having said parallel output signals applied as inputs thereto, for transmitting said one parallel output signal corresponding to the sampled signal to said processor on receipt of said second one (R3·R6·R7) of said timing reference signals.

3. A signal monitoring circuit as in claim 1 wherein said signal producing means is further characterized by:

addressable means (28) for storing data representing characters to be displayed on a screen of a raster scanned cathode ray tube;

means (24) for addressing said storage means in relation to corresponding raster scan positions on said screen;

means (34, 38) for converting character data into said serial output signal, said serial output signal controlling generation of said characters on said screen; and

means (30, 32) for storing selected character data in said addressable storage means (28) at a selected address, said selected character data being converted into said selected portion of said serial output signal by said converting means when said means for addressing (24) generates said selected address.

4. A signal monitoring circuit as in claim 3 wherein said means for sampling and monitoring is characterized by means (30, 32) for monitoring the sampled signal corresponding to said selected portion of said serial output signal by comparing it to the stored reference signal from the addressable storage means (28).

## Patentansprüche

1. Signalüberwachungs-Schaltungsanordnung für eine Diagnose-Selbstprüfschaltung einer Rasterabtast-Anzeigeeinrichtung mit einem Schaltungsteil zum Vergleich eines gespeicherten Referenzsignals mit einem getasteten Signal, gekennzeichnet durch:

einen Schaltungsteil (10, 22) zum Vergleich einer Vielzahl von zeitlich zueinander in Beziehung stehenden Referenz-Zeittaktsignalen (V, H, S, G, R3·R6·R7);

einen Signalgenerator-Schaltungsteil (24, 28, 30, 32, 34, 38) zur Erzeugung eines seriellen Ausgangssignals, wobei die Erzeugung dieses seriellen Ausgangssignals durch eines (G) der Referenz-Zeittaktsignale getaktet wird;

einen das serielle Ausgangssignal aufnehmenden Schaltungsteil (48) zur Erzeugung einer Folge von parallelen Ausgangssignalen entsprechend den aufeinanderfolgenden Teilen des seriellen Ausgangssignals, wobei die Erzeugung der parallelen Ausgangssignale durch eines (G) der Referenz-Zeittaktsignale getaktet wird; und

einen die parallelen Ausgangssignale aufnehmenden Schaltungsteil (28, 30, 32, 50) zur Tastung und Überwachung eines der parallelen Ausgangssignale entsprechend einem ausgewählten Teil des seriellen Ausgangssignals zwecks Bildung des getasteten Signals, wobei die Tastung des einen parallelen Ausgangssignal durch ein zweites (R3·R6·R7) der Referenz-Zeittaktsignale getaktet wird.

2. Signalüberwachungs-Schaltungsanordnung nach Anspruch 1, dadurch gekennzeichnet, daß der Tast- und Überwachungsschaltungsteil folgende Komponenten aufweist:

einen Prozessor (30, 32) zur Aufnahme des einen parallelen Ausgangssignals entsprechend dem getasteten Signal sowie zum Vergleich des getasteten Signals mit dem gespeicherten Referenzsignal; und

einen die parallelen Ausgangssignale als Eingangssignale erhaltenden Pufferschaltungsteil (50) zur Übertragung des einen parallelen Ausgangssignals entsprechend dem getasteten Signal zum Prozessor beim Empfang des zweiten (R3·R6·R7) der Zeittakt-Referenzsignale.

3. Signalüberwachungs-Schaltungsanordnung nach Anspruch 1, dadurch gekennzeichnet, daß der Signalerzeugungs-Schaltungsteil folgende Komponenten aufweist:

einen adressierbaren Schaltungsteil (28) zur Speicherung von Daten, welche die auf einem Schirm einer Rasterabtast-Kathodenstrahlröhre anzuzeigenden Zeichen repräsentieren;

einen Schaltungsteil (24) zur Adressierung des Speicherschaltungsteils in Bezug auf entsprechende Rasterabtaststellen auf dem Schirm;

einen Schaltungsteil (34, 38) zur Überführung der Zeichendaten in das serielle Ausgangssignal, das die Erzeugung der Zeichen auf dem Schirm steuert; und

einen Schaltungsteil (30, 32) zur Speicherung ausgewählter Zeichendaten in dem adressierbaren Speicherschaltungsteil (28) in einer vorgegebenen Adresse, wobei die ausgewählten Zeichendaten durch den Überführungsschaltungsteil in den ausgewählten Teil des seriellen Ausgangssignal übertragen werden, wenn der Adressierungsschaltungsteil (24) die ausgewählte Adresse erzeugt.

4. Signalüberwachungs-Schaltungsanordnung nach Anspruch 3, dadurch gekennzeichnet, daß der Tast- und Überwachungs-Schaltungsteil eine Teilschaltung (30, 32) zur Überwachung des getasteten Signals entsprechend dem ausgewählten Teil des seriellen Ausgangssignals durch dessen Vergleich mit dem gespeicherten Referenzsignal vom adressierbaren Speicherschaltungsteil (28) aufweist.

**Revendications**

1. Circuit de contrôle de signaux pour un circuit de diagnostic autocontrôlé d'un dispositif d'affichage du type à trame de balayage, comportant des moyens pour comparer un signal de référence mémorisé à un signal échantillonné, caractérisé par:

des moyens (10, 22) pour produire une série de signaux de synchronisation de référence (V, H, S, G, R3·R6·R7) en relation temporelle entre eux;

des moyens de production de signal (24, 28, 30, 32, 34, 38) pour produire un signal de sortie en série, la production dudit signal de sortie en série étant synchronisée par un premier (G) desdits signaux de synchronisation de référence;

des moyens (48) branchés pour recevoir ledit signal de sortie en série et destinés à produire une suite de signaux de sortie en parallèle correspondant à des parties successives dudit signal de sortie en série, la production desdits signaux de sortie en parallèle étant synchronisé par ledit premier desdits signaux de synchronisation de référence; et

des moyens (28, 30, 32, 50) branchés pour recevoir lesdits signaux de sortie en parallèle et destinés à échantillonner et contrôler l'un desdits signaux de sortie en parallèle correspondant à une partie sélectionnée dudit signal de sortie en série pour former le signal échantillonné, l'échantillonnage dudit signal de sortie en parallèle étant synchronisé par un deuxième signal (R3·R6·R7) parmi les signaux de synchronisation de référence.

2. Circuit de contrôle de signaux selon la revendication 1, dans lequel les moyens d'échantillonnage et de contrôle sont en outre caractérisés par:

un processeur (30, 32) pour recevoir ledit signal de sortie en parallèle correspondant au signal échantillonné et pour comparer le signal échantillonné au signal de référence mémorisé; et

des moyens de verrouillage (50), recevant lesdits signaux de sortie en parallèle appliqués en tant qu'entrées, pour transmettre ledit signal de sortie en parallèle correspondant au signal échantillonné audit processeur lors de la réception du deuxième signal (R3·R6·R7) parmi les signaux de synchronisation de référence.

3. Circuit de contrôle de signaux selon la revendication 1, dans lequel lesdits moyens de production de signaux sont en outre caractérisés par:

des moyens adressables (28) pour mémoriser des données représentant des caractères à afficher sur un écran d'un tube à rayons cathodiques à trame de balayage;

des moyens (24) pour adresser lesdits moyens de mémorisation en liaison avec les positions de balayage correspondantes sur ledit écran;

des moyens (34, 38) pour convertir des données de caractères dans ledit signal de sortie en série, ledit signal de sortie en série commandant la production desdits caractères sur ledit écran; et

des moyens (30, 32) pour mémoriser des données de caractères sélectionnées dans lesdits moyens de mémorisation adressables (28) suivant une adresse sélectionnée, lesdites données de caractères sélectionnées étant converties dans ladite partie sélectionnée dudit signal de sortie en série par lesdits moyens de conversion quand lesdits moyens d'adressage (24) produisent ladite adresse sélectionnée.

4. Circuit de contrôle de signaux selon la revendication 3, dans lequel lesdits moyens destinés à échantillonner et contrôler sont caractérisés par des moyens (30, 32) pour contrôler le signal échantillonné correspondant à ladite partie sélectionnée dudit signal de sortie en série en le comparant au signal de référence mémorisé provenant des moyens de mémorisation adressables (28).

FIG. 1

FIG. 2

200th LINE    58    20

FIG. 3A

8 LINES    58
8 PIXELS

CHARACTOR "T"

| 0 | 1 | 1 | 1 | 1 | 1 | 0 | 0 |
| 0 | 0 | 0 | 1 | 0 | 0 | 0 | 0 |
| 0 | 0 | 0 | 1 | 0 | 0 | 0 | 0 |
| 0 | 0 | 0 | 1 | 0 | 0 | 0 | 0 |
| 0 | 0 | 0 | 1 | 0 | 0 | 0 | 0 |
| 0 | 0 | 0 | 1 | 0 | 0 | 0 | 0 |
| 0 | 0 | 0 | 1 | 0 | 0 | 0 | 0 |
| 0 | 0 | 0 | 0 | 0 | 0 | 0 | 0 |

FIG. 3B

TIME OF
ONE PIXEL

A

B          LOW

C

D          HIGH

E

FIG. 4

0 132 925